# FASCICULE DE BREVET EUROPEEN

(11) **EP 2 951 875 B1**
(45) Date de publication et mention de la délivrance du brevet: **14.06.2017**
(21) Numéro de dépôt: 13802968.1
(22) Date de dépôt: 10.12.2013
(51) Int. Cl.: G01M 3/00, G01M 3/20, H01M 8/04664, H01M 8/1018, H01M 8/0444, H01M 8/04746, H01M 8/249, H01M 8/2485, H01M 8/04828

(54) **PROCÉDÉ DE DÉTECTION D'UNE FUITE DE FLUIDE RÉDUCTEUR AU TRAVERS D'UNE MEMBRANE ÉLECTROLYTIQUE D'UNE CELLULE ÉLECTROCHIMIQUE**
VERFAHREN ZUR ERKENNUNG VON LECKAGEN EINER REDUZIERENDEN FLÜSSIGKEIT IN EINER ELEKTROLYTISCHEN MEMBRAN EINER ELEKTROCHEMISCHEN ZELLE
METHOD FOR DETECTING LEAKAGE OF A REDUCING FLUID THROUGHOUT AN ELECTROLYTE MEMBRANE OF AN ELECTROCHEMICAL CELL

(30) Priorité: 30.01.2013 FR 1350793
(43) Date de publication de la demande: 09.12.2015
(73) Titulaire: Areva Stockage d'Energie, 13547 Aix en Rpovence Cedex 4 (FR)
(72) Inventeur: CHAUDRON, Valery, F-04100 Manosque (FR); RAKOTONDRAINIBE, André, F-13090 Aix En Provence (FR)
(74) Mandataire: Lavoix
(86) Numéro de dépôt international: PCT/EP2013/076126
(87) Numéro de publication internationale: WO 2014/117893

(56) Documents cités:
- EP-A2- 0 827 226
- WO-A2-2004/027369
- JP-A- H1 167 255

## Description

La présente invention concerne un procédé de détection d'une fuite de fluide réducteur au travers d'une membrane électrolytique d'une cellule électrochimique, la membrane étant interposée entre un conduit anodique pour la circulation d'un flux anodique, comprenant le fluide réducteur, le long d'un premier côté de la membrane, et un conduit cathodique pour la circulation d'un flux cathodique, comprenant le fluide oxydant, le long d'un deuxième côté de la membrane, la cellule électrochimique comprenant des moyens de circulation d'un courant électrique entre les deux côtés de la membrane.

Cette cellule électrochimique fait par exemple partie d'un empilement de cellules électrochimiques d'un système de pile à combustible.

On connaît des systèmes de pile à combustible comportant des empilements de cellules électrochimiques comprenant chacune un conduit cathodique, un conduit anodique, et une membrane électrolytique interposée entre les deux conduits. La membrane électrolytique est destinée à servir de barrière entre un fluide réducteur circulant dans le conduit anodique, et un fluide oxydant circulant dans le conduit cathodique. La membrane électrolytique est néanmoins adaptée pour être traversée par des protons, de façon à permettre la survenue d'une réaction d'oxydoréduction dans la cellule électrochimique entre le fluide réducteur et le fluide oxydant.

Cette réaction d'oxydoréduction génère un courant électrique qui est collecté aux extrémités de chaque empilement, et est utilisé pour alimenter une charge.

Il s'avère cependant que les membranes électrolytiques des cellules ne sont en règle générale pas parfaitement étanches au fluide réducteur, et que cette étanchéité tend à diminuer à mesure que la membrane vieillit. Il a ainsi été observé, dans les systèmes de pile à combustible connus que, au bout d'un certain temps de fonctionnement de chaque système, les membranes électrolytiques de certaines cellules du système devenaient perméables au fluide réducteur, ce qui occasionnait une baisse importante des performances du système de pile à combustible. Par exemple, pour une membrane échangeuse de proton (PEM) de type Nafion 112 ayant une épaisseur d'environ 50 µm, le niveau d'étanchéité est considéré comme anormal lorsque le courant dit de « crossover », c'est à dire le courant de perméation de l'hydrogène du conduit anodique vers le conduit cathodique, devient supérieur à un courant équivalent de 1 mA/cm².

En règle générale, la perte d'étanchéité de la membrane électrolytique est très disparate et ne concerne que certaines cellules du système de pile à combustible. Il est donc souhaitable de pouvoir identifier les cellules concernées, afin de pouvoir les remplacer. A cet effet, il a été développé des procédés de détection de fuite, dans lesquels la tension aux bornes de chaque cellule du système de pile à combustible est suivie, de façon à identifier des baisses de tension aux bornes des cellules.

Cependant, une baisse de tension aux bornes d'une cellule peut avoir d'autres causes que la seule perte d'étanchéité de la membrane, comme par exemple un engorgement fluidique de la cellule par accumulation d'eau dans le conduit anodique ou cathodique, ou un assèchement local de la membrane de la cellule, ou un phénomène de court-circuit aux bornes de la cellule.

D'autre part, une perte d'étanchéité significative au niveau de la cellule ne conduit pas systématiquement à une baisse significative de la tension de cellule.

Pour lever cette ambiguïté, il a été développé un procédé de détection de fuite dans lequel le suivi de la tension aux bornes des cellules du système de pile à combustible est couplé à une mesure de la concentration en fluide réducteur dans le flux sortant d'un collecteur cathodique d'un empilement de cellules, ledit collecteur collectant les flux sortant des conduits cathodiques de toutes les cellules de l'empilement. Ainsi, si une baisse de tension aux bornes d'une cellule de l'empilement est observée en même temps qu'une hausse de la concentration en fluide réducteur mesurée, il est déduit que la baisse de tension a pour origine une perte d'étanchéité de la membrane électrolytique de la cellule.

Un tel procédé est connu de US 5 763 113.

Cependant, ce procédé ne permet pas d'identifier de faibles variations de la perméabilité des membranes des cellules de l'empilement. En outre, ce procédé nécessite de conserver des capteurs de tension pour mesurer la tension aux bornes de chaque cellule, ce qui rend le système de pile à combustible coûteux et complexe.

D'autres procédés de détection d'une fuite de fluide réducteur dans un système de pile à combustible sont connus de JP H11 67255 A et de WO 2004/027369 A2.

Un objectif de l'invention est de proposer un procédé adapté pour identifier de faibles variations de la perméabilité de la membrane électrolytique. Un autre objectif est que ce procédé puisse être mis en oeuvre sur un système de pile à combustible simple et économique.

A cet effet, l'invention a pour objet un procédé du type précité, comprenant les étapes successives suivantes :
- alimentation de la cellule en flux anodique et cathodique, le flux anodique étant à une première pression et circulant à un premier débit dans le conduit anodique, le flux cathodique étant à une deuxième pression et circulant à un deuxième débit dans le conduit cathodique, et un courant d'une première intensité étant échangé entre les deux côtés de la membrane,
- variation brusque et commandée d'au moins un paramètre parmi les paramètres suivants :
   ∘ pression du flux anodique dans le conduit anodique,
   ∘ pression du flux cathodique dans le conduit cathodique,
   ∘ débit du flux anodique dans le conduit anodique,
   ∘ débit du flux cathodique dans le conduit cathodique, et
   ∘ intensité du courant échangé entre les deux côtés de la membrane,
- mesure d'une première concentration en fluide réducteur dans un premier flux comprenant le flux cathodique sortant du conduit cathodique, et
- déduction de la présence ou de l'absence d'une fuite en fonction de l'évolution dans le temps de la première concentration en fluide réducteur mesurée.

Selon des modes de réalisation préférés de l'invention, le procédé présente également l'une ou plusieurs des caractéristiques suivantes, prise(s) isolément ou suivant toute(s) combinaison(s) techniquement possible(s) :
- le premier flux est constitué par le flux cathodique sortant du conduit cathodique ;
- la cellule électrochimique fait partie d'un empilement d'une pluralité de cellules électrochimiques, le flux cathodique sortant de chacune desdites cellules électrochimiques étant collecté dans un collecteur cathodique commun aux cellules électrochimiques, le premier flux étant un flux circulant en un premier point de mesure dudit collecteur cathodique ;
- ledit procédé de détection comprend les étapes supplémentaires suivantes :
   ∘ mesure d'une deuxième concentration en fluide réducteur dans un deuxième flux circulant en un deuxième point de mesure du collecteur cathodique,
   ∘ comparaison des première et deuxième concentrations en fluide réducteur mesurées l'une à l'autre, et
   ∘ localisation de la fuite parmi les cellules de l'empilement en fonction de la variation dans le temps l'une par rapport à l'autre desdites première et deuxième concentrations mesurées.
- le deuxième point de mesure est disposé en amont de la cellule dans laquelle la fuite est détectée, suivant un sens de circulation de fluide dans le collecteur cathodique ;
- l'empilement de cellules électrochimiques fait partie d'un système de pile à combustible comprenant l'empilement, une vanne multivoies et un capteur de dihydrogène, le procédé comprenant les étapes supplémentaires suivantes :
   ∘ mise en communication fluidique d'une première voie d'entrée de la vanne multivoies, raccordée fluidiquement au premier point de mesure, avec une voie de sortie de la vanne multivoies, raccordée fluidiquement au capteur de dihydrogène, puis
   ∘ mesure de la première concentration en fluide réducteur par le capteur de dihydrogène.
- ledit procédé de détection comprend les étapes supplémentaires suivantes :
   ∘ mise en communication fluidique d'une deuxième voie d'entrée de la vanne multivoies, raccordée fluidiquement au deuxième point de mesure, avec la voie de sortie de la vanne multivoies, puis
   ∘ mesure de la deuxième concentration en fluide réducteur par le capteur de dihydrogène.
- le système de pile à combustible comprend un deuxième empilement de cellules électrochimiques, le procédé comprenant les étapes supplémentaires suivantes :
   ∘ mise en communication fluidique d'une troisième voie d'entrée de la vanne multivoies, raccordée fluidiquement à un collecteur cathodique du deuxième empilement, avec la voie de sortie de la vanne multivoies, puis
   ∘ mesure, par le capteur de dihydrogène, d'une troisième concentration en fluide réducteur dans un troisième flux circulant dans le collecteur cathodique du deuxième empilement ;
- la variation brusque du débit du flux cathodique dans le conduit cathodique est obtenue par réinjection d'une partie du flux cathodique sortant en entrée du conduit cathodique ;
- lors de l'étape de variation brusque, au moins deux des paramètres varient simultanément ou séquentiellement.

L'invention a également pour objet un système de pile à combustible, comprenant au moins une cellule électrochimique, la ou chaque cellule électrochimique comprenant :
- une membrane électrolytique,
- un conduit anodique pour la circulation d'un flux anodique, comprenant un fluide réducteur, le long d'un premier côté de la membrane,
- un conduit cathodique pour la circulation d'un flux cathodique, comprenant le fluide oxydant, le long d'un deuxième côté de la membrane,
- des moyens de circulation d'un courant électrique entre les deux côtés de la membrane,
- des moyens d'alimentation de la ou chaque cellule en flux anodique et cathodique, le flux anodique étant à une première pression et circulant à un premier débit dans le conduit anodique, le flux cathodique circulant à un deuxième débit dans le conduit cathodique,
- des moyens de commande d'au moins un paramètre parmi les paramètres suivants :
   ∘ pression du flux anodique dans le conduit anodique de la ou chaque cellule,
   ∘ pression du flux cathodique dans le conduit cathodique de la ou chaque cellule,
   ∘ débit du flux anodique dans le conduit anodique de la ou chaque cellule,
   ∘ débit du flux cathodique dans le conduit cathodique de la ou chaque cellule, et
   ∘ intensité du courant échangé entre les deux côtés de la membrane de la ou chaque cellule,
- au moins un capteur, pour mesurer une première concentration en fluide réducteur dans un premier flux comprenant le flux cathodique sortant du conduit cathodique de la ou d'au moins une des cellule(s) électrochimique(s), et
- des moyens de détection d'une fuite de fluide réducteur au travers de la membrane électrolytique de la ou de l'une des cellule(s) électrochimique(s), en fonction de l'évolution dans le temps de la première concentration en fluide réducteur mesurée.

Selon des modes de réalisation préférés de l'invention, le système de pile à combustible présente également l'une ou plusieurs des caractéristiques suivantes, prise(s) isolément ou suivant toute(s) combinaison(s) techniquement possible(s) :
- ledit système de pile à combustible comprend une pluralité de cellules électrochimiques regroupées au sein d'un premier empilement, ledit premier empilement comprenant un premier collecteur cathodique, pour collecter le flux cathodique sortant du conduit cathodique de chaque cellule électrochimique de l'empilement, le premier flux étant un flux circulant en un premier point de mesure dudit collecteur cathodique ;
- ledit système de pile à combustible comprend une vanne multivoies pour mettre le capteur en communication fluidique sélectivement avec le premier point de mesure, ou avec un deuxième point de mesure du premier collecteur cathodique ;
- ledit système de pile à combustible comprend un deuxième empilement de cellules électrochimiques avec un deuxième collecteur cathodique, et une vanne multivoies pour mettre le capteur en communication fluidique sélectivement avec le premier point de mesure, ou avec un troisième point de mesure du deuxième collecteur cathodique ; et
- ledit système de pile à combustible comprend un dispositif de réinjection d'une partie du flux cathodique sortant de la ou chaque cellule électrochimique en entrée du conduit cathodique de la ou chaque cellule électrochimique.

D'autres caractéristiques et avantages de l'invention apparaîtront à la lecture de la description qui va suivre, donnée uniquement à titre d'exemple et faite en se référant aux dessins annexés, dans lesquels :
- la Figure 1 est une vue schématique en coupe d'un système de pile à combustible selon une première variante de l'invention,
- la Figure 2 est une vue schématique en coupe d'une cellule électrochimique du système de la Figure 1, sur laquelle est matérialisé par la référence I le plan de coupe de la Figure 1,
- la Figure 3 est une vue schématique en coupe d'un système de pile à combustible selon une deuxième version de l'invention,
- la Figure 4 est une vue schématique en coupe d'un système de pile à combustible selon une troisième version de l'invention,
- la Figure 5 est une vue schématique en coupe d'un système de pile à combustible selon une quatrième version de l'invention,
- la Figure 6 est un graphique représentant les évolutions dans le temps d'un débit de flux anodique dans un empilement de cellules du système de la Figure 3, et d'une concentration en fluide réducteur mesurée, et
- la Figure 7 est un graphique illustrant les évolutions dans le temps de quatre concentrations en fluide réducteur mesurées.

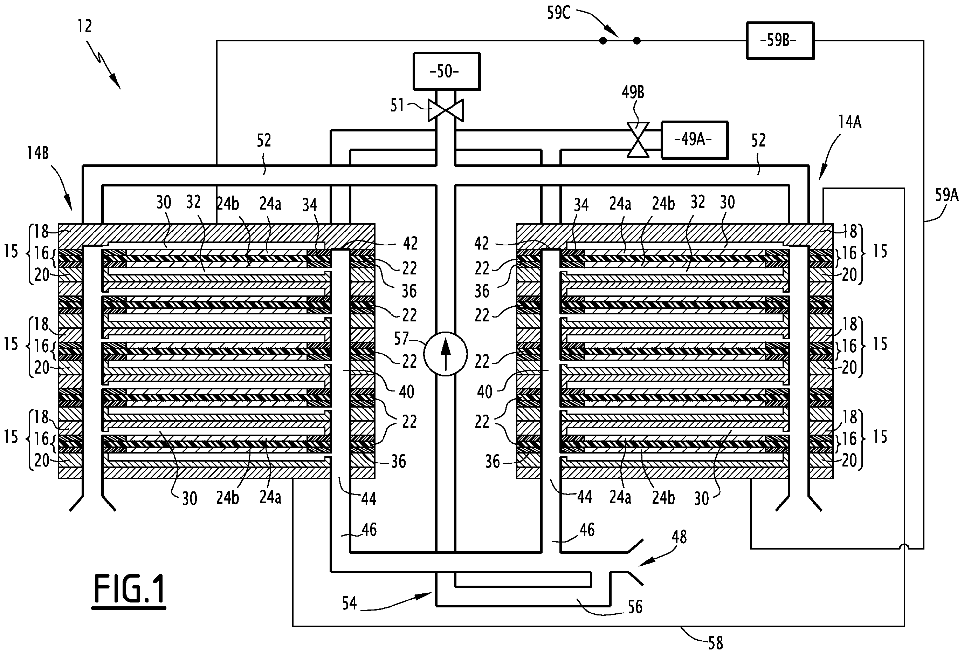

Le système de pile à combustible 12, représenté sur les Figures 1, 3, 4 et 5, est adapté pour produire un courant électrique par une réaction d'oxydoréduction entre un fluide oxydant et un fluide réducteur. A cet effet, il comprend deux empilements 14A, 14B de cellules électrochimiques 15, empilées selon une direction longitudinale d'empilement.

On notera que ce nombre de deux empilements 14A, 14B est purement arbitraire, et que le système de pile à combustible 12 peut comprendre un nombre quelconque d'empilements 14A, 14B, sans sortir du cadre de l'invention.

De même, bien que, dans l'exemple représenté, chaque empilement 14A, 14B comprend cinq cellules 15, ce nombre est purement arbitraire. En variante, le nombre de cellules 15 par empilement 14A, 14B est inférieur ou supérieur à cinq.

Chaque cellule 15 comprend un assemblage membrane-électrode 16 intercalé selon la direction longitudinale entre une plaque conductrice anodique 18 et une plaque conductrice cathodique 20.

L'assemblage membrane-électrode 16 comprend une membrane 22 électrolytique prise en sandwich selon la direction longitudinale entre une anode 24a et une cathode 24b.

La membrane 22 sépare les fluides oxydant et réducteur.

La membrane 22 est généralement une membrane conductrice de protons, adaptée pour ne laisser que des protons la traverser. En particulier, la membrane 22 forme une barrière aux électrons libres. Ainsi, elle isole électriquement l'anode 24a de la cathode 24b, et la plaque anodique 18 de la plaque cathodique 20.

La membrane 22 est typiquement en matériau polymère.

L'anode 24a et la cathode 24b comprennent chacune un catalyseur, typiquement du platine ou un alliage de platine, pour faciliter la réaction. Elles sont disposées au droit l'une de l'autre de part et d'autre de la membrane 22, et définissent ensemble une zone active de la cellule 15 où se produit la réaction d'oxydoréduction électrochimique.

La plaque anodique 18 délimite un conduit anodique 30 pour la circulation d'un flux anodique, comprenant le fluide réducteur, le long de l'anode 24a et en contact avec celle-ci. Pour ce faire, la plaque 18 est munie d'au moins un canal ménagé dans la face de la plaque 18 tournée vers l'assemblage membrane-électrode 16 et refermé par ledit assemblage membrane électrode 16. La plaque anodique 18 est formée d'un matériau conducteur électriquement, typiquement un composite constitué de polymère chargé en graphite. Le fluide réducteur est par exemple du dihydrogène.

La plaque cathodique 20 délimite un conduit cathodique 32 pour la circulation d'un flux cathodique comprenant le fluide oxydant le long de la cathode 24b et en contact avec celle-ci. Pour ce faire, la plaque 20 est munie d'au moins un canal ménagé dans la face de la plaque 20 tournée vers l'assemblage membrane-électrode 16 et refermé par ledit assemblage membrane électrode 16. La plaque cathodique 20 est formée d'un matériau conducteur électriquement, typiquement un composite constitué de polymère chargé en graphite. Le fluide oxydant est par exemple du dioxygène.

L'anode 24a est en contact électrique avec la plaque anodique 18. La cathode 24b est en contact électrique avec la plaque cathodique 20. C'est au niveau de l'anode 24a qu'a lieu l'oxydation du fluide réducteur et que les électrons et les protons sont générés. Les électrons transitent ensuite via la plaque anodique 18 vers la cathode 24b d'une cellule 15 voisine, pour participer à la réduction du fluide oxydant dans la cellule 15 voisine.

Dans chaque empilement 14A, 14B, la plaque anodique 18 de chaque cellule 15 de l'empilement 14A, 14B est en contact avec la plaque cathodique 20 de la cellule 15 voisine. Les plaques conductrices 18, 20 assurent ainsi le transfert des électrons du fluide réducteur circulant dans une des cellules 15 de l'empilement 14A, 14B vers le fluide oxydant circulant dans une autre cellule 15 de l'empilement 14A, 14B. De préférence, un canal (non représenté) pour la circulation d'un fluide de refroidissement est formé à l'interface entre les plaques anodique 18 et cathodique 20.

En variante, les plaques anodique 18 et cathodique 20 de deux cellules 15 voisines de l'empilement 14A, 14B sont venues de matière et forment ensemble une plaque bipolaire.

La cellule 15 comprend en outre des joints 34, 36 pour assurer l'étanchéité entre les plaques conductrices 18, 20 d'une part et l'assemblage membrane-électrode 16 d'autre part. Un premier joint 34 est interposé selon la direction longitudinale entre la plaque conductrice anodique 18 et la membrane 22, et un deuxième joint 36 est interposé selon la direction longitudinale entre la plaque conductrice cathodique 20 et la membrane 22, au droit du premier joint 34. Chaque joint, respectivement 34, 36, s'étend autour de l'anode 24a, respectivement de la cathode 24b.

Les cellules 15 sont maintenues empilées grâce à des plaques de serrage (non représentées) disposées aux extrémités longitudinales de l'empilement 14A, 14B. Des boulons de serrage (non représentés) exercent une force de serrage sur ces plaques pour les maintenir en compression contre les cellules 15.

Le conduit cathodique 32 de chaque cellule 15 de chaque empilement 14A, 14B débouche dans un collecteur cathodique de sortie 40 de l'empilement 14A, 14B. Le collecteur cathodique de sortie 40 est adapté pour collecter le flux cathodique sortant de chaque cellule 15 de l'empilement 14A, 14B.

Le collecteur cathodique de sortie 40 s'étend suivant la direction longitudinale de l'empilement 14A, 14B. Il est fermé à une extrémité longitudinale 42, et débouche par une extrémité longitudinale opposée 44 dans un conduit 46 d'évacuation des flux cathodiques sortants hors de l'empilement 14A, 14B.

Le conduit d'évacuation 46 relie fluidiquement le collecteur cathodique de sortie 40 à un évent 48. Dans l'exemple représenté, l'évent 48 est commun aux deux empilements 14A, 14B.

Le système de pile à combustible 12 comprend également une source 49A d'alimentation de chaque cellule 15 en fluide réducteur, une vanne 49B de régulation du débit et de la pression d'alimentation en fluide réducteur, une source 50 d'alimentation de chaque cellule 15 en fluide oxydant, et une vanne 51 de régulation du débit et de la pression d'alimentation en fluide oxydant.

La source d'alimentation 49A est typiquement un réservoir de fluide réducteur.

La source d'alimentation 50 est typiquement un compresseur à air ou un réservoir de fluide oxydant.

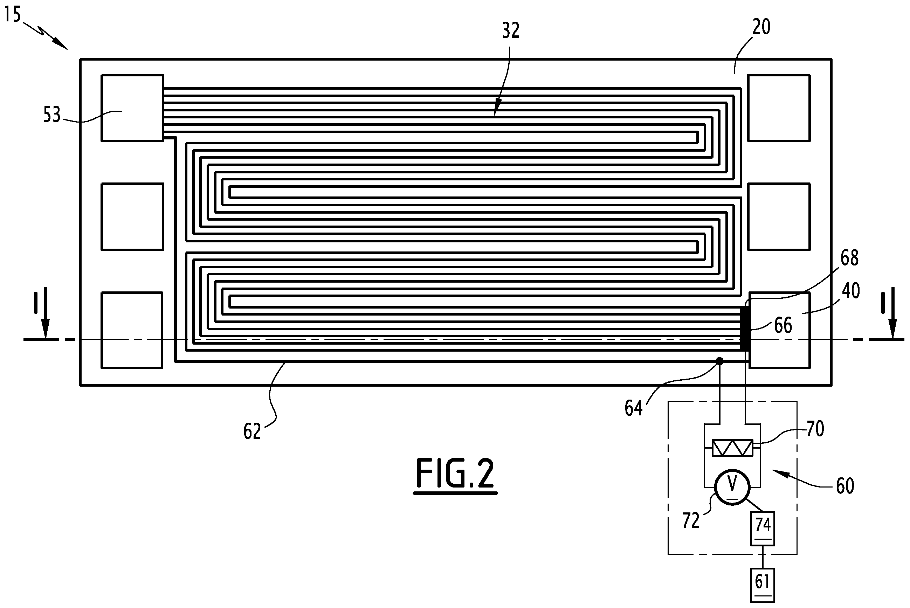

Le système de pile à combustible 12 comprend également deux conduits 52 d'alimentation en fluide oxydant, chacun propre à un empilement 14A, 14B respectif. Chaque conduit d'alimentation 52 relie fluidiquement la source d'alimentation 50 à un collecteur cathodique d'entrée 53 (Figure 2) de l'empilement 14A, 14B respectif.

Le collecteur cathodique d'entrée 53 communique fluidiquement avec le conduit cathodique 32 de chaque cellule 15 de l'empilement 14A, 14B, et est adapté pour alimenter ledit conduit cathodique 32 en fluide oxydant.

Le système de pile à combustible 12 comprend de plus un dispositif 54 de recirculation du flux cathodique. Le dispositif 54 est adapté pour prélever une partie du flux cathodique en sortie de chaque empilement 14A, 14B, et pour le réinjecter en entrée de chaque empilement 14A, 14B.

A cet effet, le dispositif de réinjection 54 comprend un conduit de réinjection 56, reliant fluidiquement l'évent 48 à chaque conduit d'alimentation 52, et une pompe 57, pour forcer la circulation d'un fluide dans le conduit 56 depuis l'évent 48 vers chaque conduit d'alimentation 52.

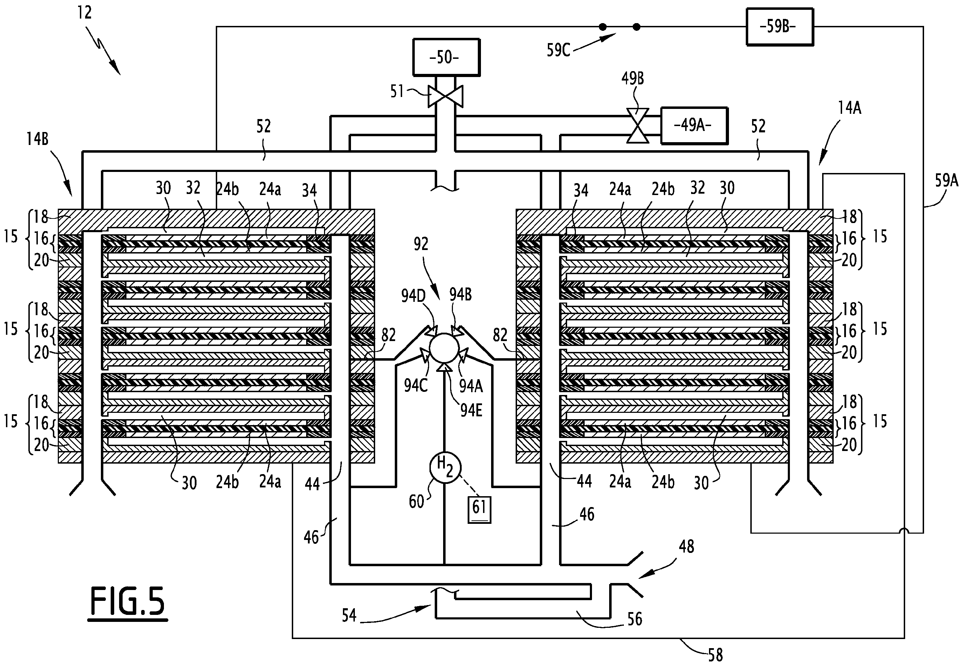

On notera que, sur la Figure 5, une partie du dispositif de réinjection 54 a été omise pour des raisons de clarté.

Les empilements 14A, 14B sont reliés électriquement en série l'un à l'autre au moyen d'une première connexion électrique 58. Une deuxième connexion électrique 59A relie électriquement les empilements 14A, 14B à une charge 59B. Un interrupteur 59C, sur la ligne 59A, est adapté pour sélectivement connecter ou déconnecter la charge 59B des empilements 14A, 14B.

Le système de pile à combustible 12 est adapté pour générer un courant nominal de charge dans la deuxième connexion électrique 59A lorsque :
- l'interrupteur 59C est fermé,
- la pression du flux cathodique dans chaque conduit cathodique 32 est égale à une pression cathodique nominale,
- la pression du flux anodique dans chaque conduit anodique 30 est égale à une pression anodique nominale,
- le débit du flux cathodique dans chaque conduit cathodique 32 est égal à un débit cathodique nominal, et
- le débit du flux anodique dans chaque conduit anodique 30 est égal à un débit anodique nominal.

Le système de pile à combustible 12 comprend enfin un premier capteur 60 (Figure 2), pour mesurer une première concentration C₁ en fluide réducteur dans un premier flux comprenant le flux cathodique sortant d'au moins une cellule 15 du système 12.

Le premier capteur 60 est adapté pour communiquer avec un module 61 de détection de fuite, adapté pour déduire la présence d'une fuite dans une cellule 15 du système 12, lorsque la première concentration C₁ dépasse une concentration seuil.

Dans la première version représentée sur les Figures 1 et 2, le premier flux est constitué par le flux cathodique sortant d'une cellule 15 du système 12.

A cet effet, ladite cellule 15 comprend, en référence à la Figure 2, un conduit 62 de contournement cathodique, en dérivation du conduit cathodique 32. Le conduit de contournement 62 relie ainsi fluidiquement le collecteur d'entrée 51 au collecteur de sortie 40, sans traverser la zone active de la cellule 15. Le fluide oxydant circulant dans ce conduit 62 n'est pas réduit.

Le conduit de contournement 62 est adapté pour que le fluide circulant à l'intérieur ait un débit plus faible que le fluide circulant dans le conduit cathodique 32.

Le premier capteur 60 comprend une première électrode 64, disposée dans le conduit de contournement 62, et une deuxième électrode 66, disposée dans une zone 68 de raccordement du conduit cathodique 32 au collecteur de sortie 40. Il comprend également une résistance 70, raccordée électriquement, par une borne, à la première électrode 64 et, par l'autre de ses bornes, à la deuxième électrode 66. Il comprend enfin un voltmètre 72, pour mesurer une tension aux bornes de la résistance 70, et un module 74 de déduction de la concentration C₁ en fonction de la tension mesurée par le voltmètre 72.

Toujours dans cette première variante, chaque autre cellule 15 du système de pile à combustible 12 comprend également un conduit de contournement cathodique similaire au conduit de contournement cathodique 62, et un capteur, identique au premier capteur 60, est associé à chacune de ces autres cellules 15 pour mesurer une concentration en fluide réducteur dans le flux cathodique sortant de ladite cellule 15.

Le premier capteur 60 et les autres capteurs sont adaptés pour communiquer avec le module de détection de fuite 61, qui est adapté pour déduire la présence d'une fuite dans une cellule 15 du système 12 lorsque la concentration en fluide réducteur mesurée par le capteur associé à ladite cellule 15 dépasse une concentration seuil.

Ainsi, il est possible de détecter pour chaque cellule 15 si une élévation anormale de la concentration en fluide réducteur dans le flux cathodique sortant de ladite cellule 15 se produit. On peut donc facilement identifier une perte d'étanchéité de la membrane 22 d'une cellule 15, et assurer un suivi très précis du vieillissement de la membrane 22 de chaque cellule 15.

Cependant, une telle solution est coûteuse, dans la mesure où elle nécessite d'intégrer un capteur dans chaque cellule 15 de chaque empilement 14A, 14B. En outre, une telle solution est complexe, dans la mesure où elle nécessite de gérer un grand nombre de capteurs de fluide réducteur pour la surveillance des cellules 15.

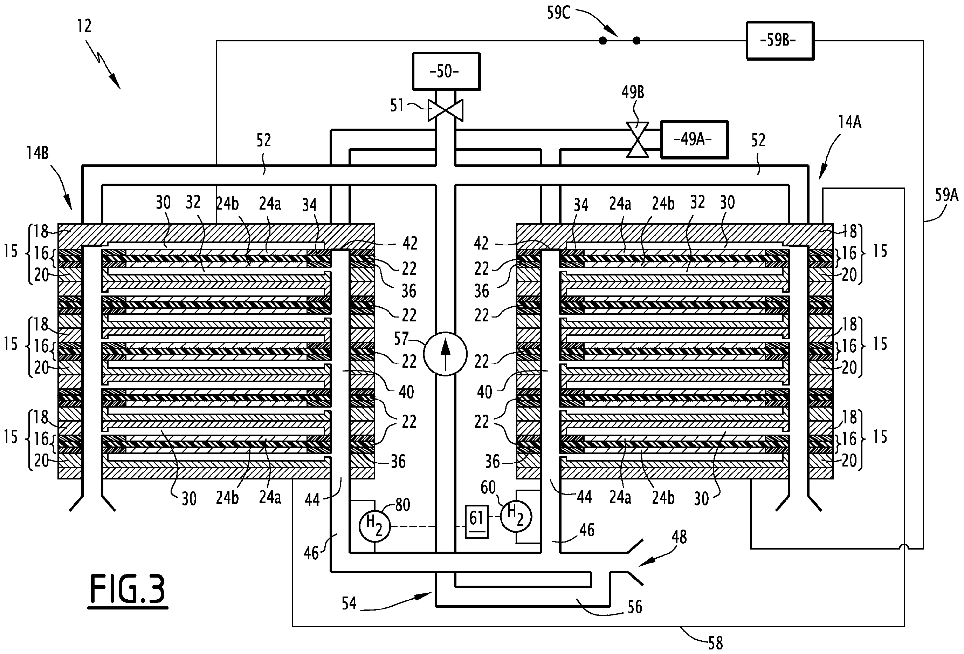

Dans les deuxième, troisième et quatrième variantes, représentées sur les Figures 3 à 5, le premier flux est un flux circulant en un premier point de mesure du collecteur cathodique de sortie 40 d'un premier 14A des empilements 14A, 14B, ce premier point de mesure étant constitué par l'extrémité débouchante 44 du collecteur cathodique de sortie 40. Le premier flux est donc le flux sortant du collecteur cathodique de sortie 40.

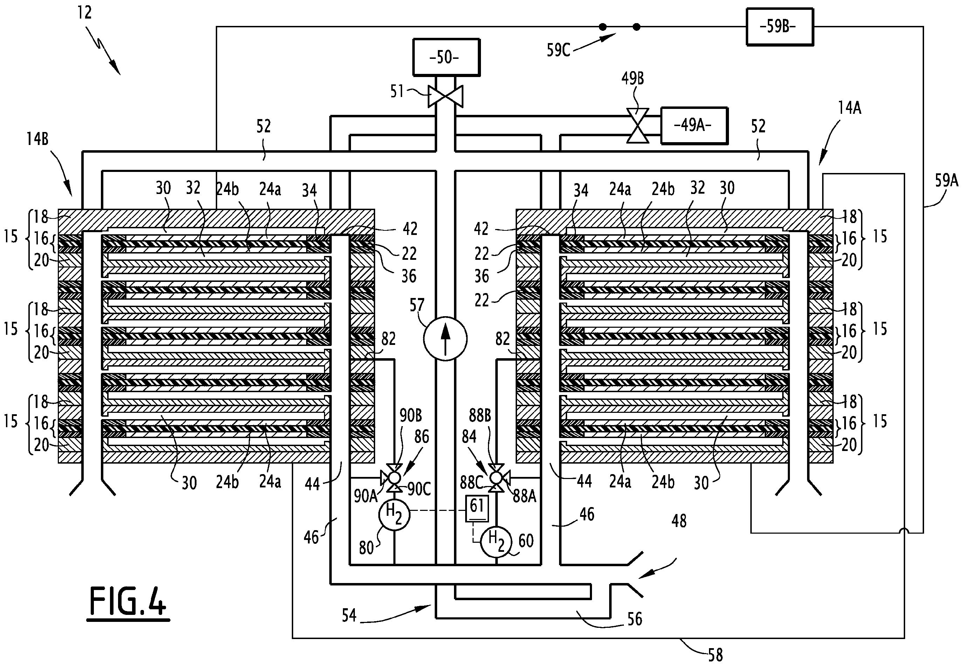

Dans les deuxième et troisième variantes, représentées sur les Figures 3 et 4, le système de pile à combustible 12 comprend également un deuxième capteur 80, pour mesurer une deuxième concentration C₂ en fluide réducteur, dans un deuxième flux comprenant le flux cathodique sortant d'au moins une cellule 15 du deuxième empilement 14B. Le deuxième flux est en particulier un flux circulant en un premier point de mesure du collecteur cathodique de sortie 40 du deuxième empilement 14B, ledit premier point de mesure étant l'extrémité débouchante 44 dudit collecteur cathodique de sortie 40. Le deuxième flux est ainsi le flux sortant du deuxième collecteur cathodique de sortie 40 du deuxième empilement 14B.

Le deuxième capteur 80 est également adapté pour communiquer avec le module de détection 61.

Dans la deuxième variante, représentée sur la Figure 3, le premier capteur 60 est adapté pour mesurer exclusivement la première concentration C₁, et le deuxième capteur 80 est adapté pour mesurer exclusivement la deuxième concentration C₂.

Le module de détection 61 est adapté pour comparer la première concentration C₁ à la deuxième concentration C₂, et pour déduire la présence d'une fuite dans l'un des empilements 14A, 14B lorsque l'une des conditions suivantes est vérifiée :
- la différence entre les concentrations C₁ et C₂ dépasse un seuil prédéterminé, ou
- la dérivée par rapport au temps de la différence entre les concentrations C₁ et C₂ dépasse un seuil prédéterminé.

Le module de détection 61 est adapté pour localiser la fuite dans l'empilement 14A, 14B associé au capteur 60, 80 ayant mesuré la concentration C₁, C₂ la plus élevée, ou présentant la dérivée par rapport au temps la plus grande.

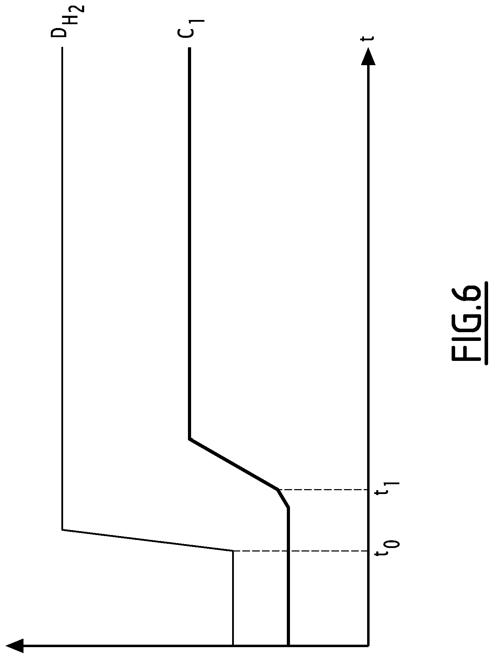

Le module de détection 61 est également adapté pour localiser la fuite parmi les cellules 15 dudit empilement 14A, 14B en fonction d'un retard entre un instant t₀ (Figure 6) de variation brusque d'un paramètre parmi les paramètres suivants :
- pression du flux anodique dans le conduit anodique 30 de la ou chaque cellule 15,
- pression du flux cathodique dans le conduit cathodique 32 de la ou chaque cellule 15,
- débit du flux anodique dans le conduit anodique 30 de la ou chaque cellule 15,
- débit du flux cathodique dans le conduit cathodique 32 de la ou chaque cellule 15, et
- intensité du courant échangé entre les deux côtés de la membrane 22 de la ou chaque cellule 15,
et un instant t₁ (Figure 6) de variation significative de la concentration C₁, C₂ mesurée.

Par « variation brusque », il est entendu que, sur une durée supérieure ou égale à 1 seconde, la dérivée par rapport au temps du paramètre considéré est supérieure à :
- 10 mbar par seconde, et de préférence supérieure à 100 mbar par seconde ou à 1% de la pression anodique nominale par seconde, pour la pression du flux anodique
- 10 mbar par seconde, et de préférence supérieure à 100 mbar par seconde ou à 1% de la pression cathodique nominale par seconde, pour la pression du flux cathodique,
- 1% du débit anodique nominal par seconde, pour le débit du flux anodique,
- 1% du débit cathodique nominal par seconde, pour le débit du flux cathodique, et
- 1% du courant nominal de charge par seconde, pour l'intensité du courant.

Par « variation significative », on comprend que la dérivée par rapport au temps de la concentration C₁, C₂ mesurée est supérieure à 40 ppm par seconde, ce qui représente 0,5% de la limite d'inflammabilité de l'hydrogène dans l'oxygène.

Dans la troisième variante, représentée sur la Figure 4, le premier capteur 60 est adapté pour mesurer une troisième concentration C₃ en fluide réducteur, dans un troisième flux circulant en un deuxième point de mesure 82 du collecteur cathodique de sortie 40 du premier empilement 14A, et le deuxième capteur 80 est adapté pour mesurer une quatrième concentration C₄ en fluide réducteur, dans un quatrième flux circulant en un deuxième point de mesure du collecteur cathodique de sortie 40 du deuxième empilement 14B.

Chaque deuxième point de mesure 82 est en amont du premier point de mesure correspondant, selon un sens de circulation de fluide dans le collecteur cathodique de sortie 40 associé. Chaque deuxième point de mesure 82 est en particulier disposé à sensiblement mi-distance des extrémités longitudinales de l'empilement 14A, 14B, de sorte qu'il y a le même nombre de cellules 15 de l'empilement 14A, 14B dont le conduit cathodique 32 débouche dans le collecteur cathodique de sortie 40 en amont et en aval du deuxième point de mesure 82.

A cet effet, le système de pile à combustible 12 comprend deux vannes multivoies 84, 86. Une première 84 des vannes multivoies 84, 86 comprend une première entrée 88A raccordée fluidiquement au premier point de mesure de l'empilement 14A, une deuxième entrée 88B raccordée fluidiquement au deuxième point de mesure 82 de l'empilement 14A, et une sortie 88C raccordée fluidiquement au capteur 60. Une deuxième 86 des vannes multivoies 84, 86 comprend une première entrée 90A raccordée fluidiquement au premier point de mesure de l'empilement 14B, une deuxième entrée 90B raccordée fluidiquement au deuxième point de mesure 82 de l'empilement 14B, et une sortie 90C raccordée fluidiquement au capteur 80.

Le module de détection 61 est adapté pour comparer les concentrations C₁, C₂, C₃, C₄ les unes aux autres, et pour déduire la présence d'une fuite dans l'un des empilements 14A, 14B lorsque l'une des conditions suivantes est vérifiée :
- la différence entre deux des concentrations C₁, C₂, C₃, C₄ dépasse un seuil prédéterminé, ou
- la dérivée par rapport au temps de la différence entre deux des concentrations C₁, C₂, C₃, C₄ dépasse un seuil prédéterminé.

Le module de détection 61 est adapté pour localiser la fuite dans :
- la moitié amont du premier empilement 14A, si la différence entre les concentrations C₃ et C₁ dépasse un seuil prédéterminé, ou que la dérivée par rapport au temps de ladite différence dépasse un seuil prédéterminé, la concentration C₃ étant la plus élevée,
- la moitié aval du premier empilement 14A, si la différence entre les concentrations C₁ et C₃ dépasse un seuil prédéterminé, ou que la dérivée par rapport au temps de ladite différence dépasse un seuil prédéterminé, la concentration C₁ étant la plus élevée,
- la moitié amont du deuxième empilement 14B, si la différence entre les concentrations C₄ et C₂ dépasse un seuil prédéterminé, ou que la dérivée par rapport au temps de ladite différence dépasse un seuil prédéterminé, la concentration C₄ étant la plus élevée, ou
- la moitié aval du deuxième empilement 14B, si la différence entre les concentrations C₂ et C₄ dépasse un seuil prédéterminé, ou que la dérivée par rapport au temps de ladite différence dépasse un seuil prédéterminé, la concentration C₂ étant la plus élevée.

Le module de détection 61 est adapté pour localiser la fuite parmi les cellules 15 de la moitié d'empilement identifiée en fonction d'un retard entre un instant t₀ (Figure 6) de variation brusque d'un paramètre parmi les paramètres suivants :
- pression du flux anodique dans le conduit anodique 30 de la ou chaque cellule 15,
- pression du flux cathodique dans le conduit cathodique 32 de la ou chaque cellule 15,
- débit du flux anodique dans le conduit anodique 30 de la ou chaque cellule 15,
- débit du flux cathodique dans le conduit cathodique 32 de la ou chaque cellule 15, et
- intensité du courant échangé entre les deux côtés de la membrane 22 de la ou chaque cellule 15,
et un instant t₁ (Figure 6) de variation significative de la concentration :
- C₁, si la fuite a été détectée comme étant dans la moitié aval du premier empilement 14A,
- C₂, si la fuite a été détectée comme étant dans la moitié aval du deuxième empilement 14B,
- C₃, si la fuite a été détectée comme étant dans la moitié amont du premier empilement 14A, et
- C₄, si la fuite a été détectée comme étant dans la moitié amont du deuxième empilement 14B.

Dans la quatrième variante, représentée sur la Figure 5, le capteur 60 est adapté pour mesurer les concentrations C₂, C₃ et C₄, en plus de la concentration C₁. A cet effet, le système de pile à combustible 12 comprend une vanne multivoies 92, comprenant :
- une première entrée 94A, raccordée fluidiquement au premier point de mesure de l'empilement 14A,
- une deuxième entrée 94B raccordée fluidiquement au deuxième point de mesure 82 de l'empilement 14A,
- une troisième entrée 94C, raccordée fluidiquement au premier point de mesure de l'empilement 14B,
- une quatrième entrée 94D, raccordée fluidiquement au deuxième point de mesure de l'empilement 14B, et
- une sortie 94E raccordée fluidiquement au capteur 60.

La vanne multivoies 92 est programmée pour raccorder successivement chaque entrée 94A, 94B, 94C, 94D à la sortie 94E, à des intervalles de temps constants.

Le module de détection 61 est adapté pour comparer les concentrations C₁, C₂, C₃, C₄ les unes aux autres, et pour déduire la présence d'une fuite dans l'un des empilements 14A, 14B lorsque l'une des conditions suivantes est vérifiée :
- la différence entre deux des concentrations C₁, C₂, C₃, C₄ dépasse un seuil prédéterminé, ou
- la dérivée par rapport au temps de la différence entre deux des concentrations C₁, C₂, C₃, C₄ dépasse un seuil prédéterminé.

Le module de détection 61 est adapté pour localiser la fuite dans :
- la moitié amont du premier empilement 14A, si la différence entre les concentrations C₃ et C₁ dépasse un seuil prédéterminé, ou que la dérivée par rapport au temps de ladite différence dépasse un seuil prédéterminé, la concentration C₃ étant la plus élevée,
- la moitié aval du premier empilement 14A, si la différence entre les concentrations C₁ et C₃ dépasse un seuil prédéterminé, ou que la dérivée par rapport au temps de ladite différence dépasse un seuil prédéterminé, la concentration C₁ étant la plus élevée,
- la moitié amont du deuxième empilement 14B, si la différence entre les concentrations C₄ et C₂ dépasse un seuil prédéterminé, ou que la dérivée par rapport au temps de ladite différence dépasse un seuil prédéterminé, la concentration C₄ étant la plus élevée, ou
- la moitié aval du deuxième empilement 14B, si la différence entre les concentrations C₂ et C₄ dépasse un seuil prédéterminé, ou que la dérivée par rapport au temps de ladite différence dépasse un seuil prédéterminé, la concentration C₂ étant la plus élevée.

Le module de détection 61 est adapté pour localiser la cellule présentant la fuite parmi les cellules 15 de la moitié d'empilement identifiée en fonction d'un retard entre un instant t₀ (Figure 6) de variation brusque d'un paramètre parmi les paramètres suivants :
- pression du flux anodique dans le conduit anodique 30 de la ou chaque cellule 15,
- pression du flux cathodique dans le conduit cathodique 32 de la ou chaque cellule 15,
- débit du flux anodique dans le conduit anodique 30 de la ou chaque cellule 15,
- débit du flux cathodique dans le conduit cathodique 32 de la ou chaque cellule 15, et
- intensité du courant échangé entre les deux côtés de la membrane 22 de la ou chaque cellule 15,
et un instant t₁ (Figure 6) de variation significative de la concentration :
- C₁, si la fuite a été détectée comme étant dans la moitié aval du premier empilement 14A,
- C₂, si la fuite a été détectée comme étant dans la moitié aval du deuxième empilement 14B,
- C₃, si la fuite a été détectée comme étant dans la moitié amont du premier empilement 14A, et
- C₄, si la fuite a été détectée comme étant dans la moitié amont du deuxième empilement 14B.

Un procédé de détection de fuite au moyen du système de pile à combustible 12 selon la quatrième variante va maintenant être décrit, en regard des Figures 5 à 7.

Selon ce procédé, les empilements 14A, 14B sont alimentés en flux cathodique et en flux anodique. Pour chaque cellule 15 de chaque empilement 14A, 14B :
- le flux anodique circule à un premier débit dans le conduit anodique 30, à une première pression,
- le flux cathodique circule à un deuxième débit dans le conduit cathodique 32, à une deuxième pression, et
- un courant d'une première intensité est échangé entre les deux côtés de la membrane 22, ladite première intensité étant supérieure ou égale à zéro.

Dans une première étape de surveillance du système de pile à combustible 12, le capteur 60 mesure les concentrations C₁, C₂, C₃, C₄ aux points de mesures correspondants. Pour ce faire, la vanne multivoies 92 raccorde successivement chaque entrée 94A, 94B, 94C, 94D à la sortie 94E, à des intervalles de temps constants.

Le module de détection 61 détermine l'évolution dans le temps de chaque concentration C₁, C₂, C₃, C₄ ainsi que les différences entre ces concentrations deux à deux.

Le module de détection 61 détermine la présence d'une fuite dans l'un des empilements 14A, 14B lorsque l'une des conditions suivantes est vérifiée :
- la différence entre deux des concentrations C₁, C₂, C₃, C₄ dépasse un seuil prédéterminé, ou
- la dérivée par rapport au temps de la différence entre deux des concentrations C₁, C₂, C₃, C₄ dépasse un seuil prédéterminé.

Lorsqu'une fuite est ainsi détectée, une deuxième étape de localisation de la fuite fait suite à la première étape de surveillance. Lors de cette deuxième étape, le module de détection 61 localise la moitié d'empilement dans laquelle est localisée la fuite en fonction de celle des conditions énoncées ci-dessus qui a été vérifiée. Le module de détection localise la fuite dans :
- la moitié amont du premier empilement 14A, si la différence entre les concentrations C₃ et C₁ dépasse un seuil prédéterminé, ou que la dérivée par rapport au temps de ladite différence dépasse un seuil prédéterminé, la concentration C₃ étant la plus élevée,
- la moitié aval du premier empilement 14A, si la différence entre les concentrations C₁ et C₃ dépasse un seuil prédéterminé, ou que la dérivée par rapport au temps de ladite différence dépasse un seuil prédéterminé, la concentration C₁ étant la plus élevée,
- la moitié amont du deuxième empilement 14B, si la différence entre les concentrations C₄ et C₂ dépasse un seuil prédéterminé, ou que la dérivée par rapport au temps de ladite différence dépasse un seuil prédéterminé, la concentration C₄ étant la plus élevée, ou
- la moitié aval du deuxième empilement 14B, si la différence entre les concentrations C₂ et C₄ dépasse un seuil prédéterminé, ou que la dérivée par rapport au temps de ladite différence dépasse un seuil prédéterminé, la concentration C₂ étant la plus élevée.

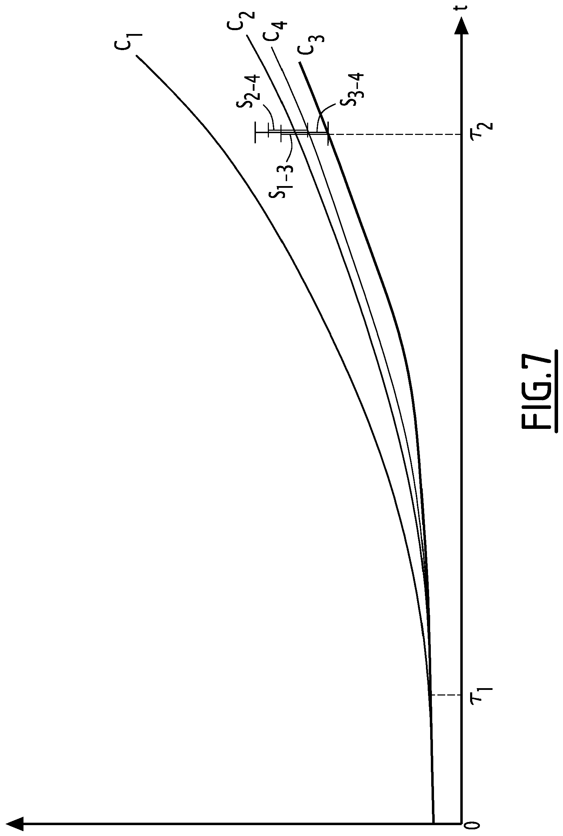

Dans l'exemple représenté sur la Figure 7, à un premier instant de mesure τ₁, les concentrations C₁, C₂, C₃, C₄ sont toutes sensiblement égales. Le module de détection 61 conclut donc à l'absence de fuite à l'instant τ₁. Cependant, à un deuxième instant de mesure τ₂, on observe que la différence entre les concentrations C₁ et C₃ est supérieure à un seuil prédéterminé S₁₋₃, la concentration C₁ étant la plus élevée, alors que la différence entre les concentrations C₃ et C₄ est inférieure à un seuil prédéterminé S₃₋₄, et que la différence entre les concentrations C₂ et C₄ est inférieure à un seuil prédéterminé S₂₋₄. Le module de détection 61 conclut donc à la présence d'une fuite dans la moitié aval du premier empilement 14A.

A la deuxième étape de localisation de la fuite, fait suite une troisième étape d'identification de la cellule 15 fuyarde. Lors de cette étape, la vanne multivoies 92 raccorde fluidiquement au capteur 60 le point de mesure qui correspond à la moitié d'empilement dans laquelle la fuite a été localisée, pour mesurer la concentration intéressante en continu et localiser individuellement la cellule 15 présentant la fuite.

En particulier, la vanne multivoie 92 raccorde au capteur 60 :
- le deuxième point de mesure du premier empilement 14A si la fuite est localisée dans la moitié amont du premier empilement 14A, pour mesurer la concentration C₃,
- le premier point de mesure du premier empilement 14A si la fuite est localisée dans la moitié aval du premier empilement 14A, pour mesurer la concentration C₁,
- le deuxième point de mesure du deuxième empilement 14B si la fuite est localisée dans la moitié amont du deuxième empilement 14B, pour mesurer la concentration C₄, et
- le premier point de mesure du deuxième empilement 14B si la fuite est localisée dans la moitié aval du deuxième empilement 14B, pour mesurer la concentration C₂.

Dans l'exemple évoqué, la vanne multivoie 92 raccorde donc le capteur 60 au premier point de mesure du premier empilement 14A.

Puis on fait varier de manière brusque et commandée, dans l'empilement dans lequel la fuite a été détectée (c'est-à-dire, dans l'exemple évoqué, le premier empilement 14A), à un instant t₀, au moins un paramètre parmi les paramètres suivants :
- pression du flux anodique dans le conduit anodique 30 de la ou chaque cellule 15 ;
- pression du flux cathodique dans le conduit cathodique 32 de la ou chaque cellule 15,
- débit du flux anodique dans le conduit anodique 30 de la ou chaque cellule 15;
- débit du flux cathodique dans le conduit cathodique 32 de la ou chaque cellule 15 ; à cet effet, la pompe de recirculation 57 est par exemple activée ; et
- intensité du courant échangé entre les deux côtés de la membrane 22 de la ou chaque cellule 15.

De préférence, on fait varier simultanément ou séquentiellement au moins deux paramètres parmi les paramètres précédents.

Dans l'exemple représenté sur la Figure 6, c'est le débit du flux anodique qui varie. En référence à cette Figure, le module de détection 61 identifie la cellule présentant la fuite parmi les cellules 15 de la moitié d'empilement identifiée en fonction d'un retard entre l'instant t₀ et un instant t₁ de variation significative de la concentration intéressante, à savoir :
- C₁, si la fuite a été détectée comme étant dans la moitié aval du premier empilement 14A,
- C₂, si la fuite a été détectée comme étant dans la moitié aval du deuxième empilement 14B,
- C₃, si la fuite a été détectée comme étant dans la moitié amont du premier empilement 14A, et
- C₄, si la fuite a été détectée comme étant dans la moitié amont du deuxième empilement 14B.

Ainsi, si l'instant t₁ est rapproché de l'instant t₀, le module de détection 61 identifie la cellule 15 fuyarde comme étant proche de l'extrémité amont de l'empilement 14A, 14B, et si l'instant t₁ est éloigné de l'instant t₀, le module de détection 61 identifie la cellule 15 fuyarde comme étant proche de l'extrémité aval de l'empilement 14A, 14B. L'homme du métier saura calibrer le module de détection 61 de façon à identifier précisément la cellule 15 concernée par la fuite en fonction du retard observé entre les instant t₀ et t₁.

On notera que ce procédé est facilement adaptable au système de pile à combustible selon la troisième version de l'invention, illustré sur la Figure 4. A cet effet, l'étape de surveillance est simplement modifiée de façon à ce que la vanne 84 raccorde successivement chaque entrée 88A, 88B à la sortie 88C, à des intervalles de temps constants, pour que le premier capteur 60 mesure les première et troisième concentrations C₁, C₃, et que la vanne 88 raccorde successivement chaque entrée 90A, 90B à la sortie 90C, à des intervalles de temps constants, pour que le deuxième capteur 80 mesure les deuxième et quatrième concentrations C₂, C₄, et l'étape d'identification de la cellule 15 fuyarde est simplement modifiée de façon à ce que la vanne, respectivement 84, 86, correspondant à l'empilement, respectivement 14A, 14B, dans laquelle la fuite a été localisée raccorde fluidiquement au capteur associé, respectivement 60, 80, le point de mesure qui correspond à la moitié d'empilement dans laquelle la fuite a été localisée.

Le procédé est également facilement adaptable au système de pile à combustible selon la deuxième version de l'invention, illustré sur la Figure 3. A cet effet, les étapes concernant les permutations de la vanne 92 sont simplement supprimées, et la détection d'une fuite se fait simplement par comparaison des première et deuxième concentrations C₁, C₂.

Le procédé de détection de fuite mis en oeuvre au moyen du système de pile à combustible selon la première version de l'invention, illustré sur les Figures 1 et 2, est différent du procédé précédent. En effet, ce procédé débute par une étape de variation, de manière brusque et commandée, dans au moins un des empilements 14A, 14B, à un instant t₀, d'au moins un paramètre parmi les paramètres suivants :
- pression du flux anodique dans le conduit anodique 30 de la ou chaque cellule 15 ;
- pression du flux cathodique dans le conduit cathodique 32 de la ou chaque cellule 15,
- débit du flux anodique dans le conduit anodique 30 de la ou chaque cellule 15;
- débit du flux cathodique dans le conduit cathodique 32 de la ou chaque cellule 15 ; à cet effet, la pompe de recirculation 57 est par exemple activée ; et
- intensité du courant échangé entre les deux côtés de la membrane 22 de la ou chaque cellule 15.

De préférence, au moins deux paramètres parmi les paramètres précédents varient simultanément ou séquentiellement lors de cette étape.

Cette variation brusque augmente le taux de perméation du fluide réducteur au travers de la membrane 22 de chaque cellule 15. Chaque capteur mesure la concentration en fluide réducteur dans le flux cathodique sortant de la cellule 15 associée, et le module de détection 61 compare les concentrations mesurées deux à deux, ainsi que leurs évolutions respectives dans le temps.

Le module de détection 61 détecte la présence d'une fuite dans l'une des cellules 15 lorsque l'une des conditions suivantes est vérifiée :
- l'une des concentrations mesurées excède de plus d'un seuil prédéterminé la moyenne des concentrations mesurées, ou
- la dérivée par rapport au temps de la différence entre l'une des concentrations mesurées et la moyenne des concentrations mesurées dépasse un seuil prédéterminé, ladite concentration mesurée étant supérieure à la moyenne des concentrations mesurées.

Le module de détection 61 identifie la cellule 15 fuyarde comme étant la cellule 15 dans laquelle ladite concentration a été mesurée.

Grâce à l'invention, le procédé de détection de fuite, qui utilise une variation brusque d'un paramètre pertinent combinée à une mesure de concentration d'un flux de fluide réducteur, permet d'identifier des fuites même faibles dans une membrane d'une cellule électrochimique.

En outre, le procédé de détection permet de détecter une fuite dans un empilement de cellules électrochimique, et de détecter ensuite précisément et individuellement la ou chaque cellule électrochimique présentant la fuite.

Le procédé peut être mise en oeuvre de manière fiable et précise sur un système de pile à combustible simple. En particulier, le procédé permet d'identifier une cellule électrochimique possédant une fuite parmi les cellules électrochimique d'un ou plusieurs empilements avec un nombre réduit de capteur de concentration de fluide réducteur dans un fluide, notamment avec un seul capteur.

## Revendications

1. Procédé de détection d'une fuite de fluide réducteur au travers d'une membrane électrolytique (22) d'une cellule électrochimique (15), la membrane (22) étant interposée entre un conduit anodique (30) pour la circulation d'un flux anodique, comprenant le fluide réducteur, le long d'un premier côté de la membrane (22), et un conduit cathodique (32) pour la circulation d'un flux cathodique, comprenant le fluide oxydant, le long d'un deuxième côté de la membrane (22), la cellule électrochimique (15) comprenant des moyens de circulation d'un courant électrique entre les deux côtés de la membrane (22), **caractérisé en ce que** le procédé comprend les étapes successives suivantes :
- alimentation de la cellule (15) en flux anodique et cathodique, le flux anodique étant à une première pression et circulant à un premier débit dans le conduit anodique (30), le flux cathodique étant à une deuxième pression et circulant à un deuxième débit dans le conduit cathodique (32), et un courant d'une première intensité étant échangé entre les deux côtés de la membrane (22),
- variation brusque et commandée d'au moins un paramètre commandé parmi les paramètres suivants :
∘ pression du flux anodique dans le conduit anodique,
∘ pression du flux cathodique dans le conduit cathodique,
∘ débit du flux anodique dans le conduit anodique,
∘ débit du flux cathodique dans le conduit cathodique, et
∘ intensité du courant échangé entre les deux côtés de la membrane,
- mesure d'une première concentration (C₁) en fluide réducteur dans un premier flux comprenant le flux cathodique sortant du conduit cathodique, et
- déduction de la présence ou de l'absence d'une fuite en fonction de l'évolution dans le temps de la première concentration en fluide réducteur (C₁) mesurée.

2. Procédé de détection selon la revendication 1, dans lequel le premier flux est constitué par le flux cathodique sortant du conduit cathodique (32).

3. Procédé de détection selon la revendication 1, dans lequel la cellule électrochimique (15) fait partie d'un empilement (14A) d'une pluralité de cellules électrochimiques, le flux cathodique sortant de chacune desdites cellules électrochimiques étant collecté dans un collecteur cathodique (40) commun aux cellules électrochimiques, le premier flux étant un flux circulant en un premier point de mesure (44) dudit collecteur cathodique (40).

4. Procédé de détection selon la revendication 3, comprenant les étapes supplémentaires suivantes :
- mesure d'une deuxième concentration (C₃) en fluide réducteur dans un deuxième flux circulant en un deuxième point de mesure (82) du collecteur cathodique (40),
- comparaison des première (C₁) et deuxième (C₃) concentrations en fluide réducteur mesurées l'une à l'autre, et
- localisation de la fuite parmi les cellules de l'empilement (14A) en fonction de la variation dans le temps l'une par rapport à l'autre desdites première et deuxième concentrations mesurées (C₁, C₃).

5. Procédé de détection selon la revendication 4, dans lequel le deuxième point de mesure (82) est disposé en amont de la cellule (15) dans laquelle la fuite est détectée, suivant un sens de circulation de fluide dans le collecteur cathodique (40).

6. Procédé de détection selon l'une quelconque des revendications 3 à 5, dans lequel l'empilement (14A) de cellules électrochimiques fait partie d'un système de pile à combustible (12) comprenant l'empilement (14A), une vanne multivoies (84, 92) et un capteur de dihydrogène (60), le procédé comprenant les étapes supplémentaires suivantes :
- mise en communication fluidique d'une première voie d'entrée (88A, 94A) de la vanne multivoies (84, 92), raccordée fluidiquement au premier point de mesure (44), avec une voie de sortie (88C, 94E) de la vanne multivoies (84, 92), raccordée fluidiquement au capteur de dihydrogène (60), puis
- mesure de la première concentration en fluide réducteur (C₁) par le capteur de dihydrogène (60).

7. Procédé de détection selon la revendication 6, comprenant les étapes supplémentaires suivantes :
- mise en communication fluidique d'une deuxième voie d'entrée (88B, 94B) de la vanne multivoies (84, 92), raccordée fluidiquement au deuxième point de mesure (82), avec la voie de sortie (88C, 94E) de la vanne multivoies (84, 92), puis
- mesure de la deuxième concentration en fluide réducteur (C₃) par le capteur de dihydrogène (60).

8. Procédé de détection selon la revendication 6 ou 7, dans lequel le système de pile à combustible (12) comprend un deuxième empilement (14B) de cellules électrochimiques, le procédé comprenant les étapes supplémentaires suivantes :
- mise en communication fluidique d'une troisième voie d'entrée (94D) de la vanne multivoies (92), raccordée fluidiquement à un collecteur cathodique (40) du deuxième empilement (14B), avec la voie de sortie (94E) de la vanne multivoies (92), puis
- mesure, par le capteur de dihydrogène (60), d'une troisième concentration (C₂) en fluide réducteur dans un troisième flux circulant dans le collecteur cathodique (40) du deuxième empilement (14B).

9. Procédé selon l'une quelconque des revendications 3 à 8, comprenant une étape de localisation de la fuite en fonction d'un retard entre l'instant (t₀) de variation brusque du paramètre commandé et un instant (t₁) de variation significative de la première concentration (C₁).

10. Procédé selon l'une quelconque des revendications précédentes, dans lequel la variation brusque du débit du flux cathodique dans le conduit cathodique (40) est obtenue par réinjection d'une partie du flux cathodique sortant en entrée du conduit cathodique.

11. Procédé selon l'une quelconque des revendications précédentes dans lequel, lors de l'étape de variation brusque, au moins deux des paramètres commandés varient simultanément ou séquentiellement.

12. Système de pile à combustible (12), comprenant au moins une cellule électrochimique (15), la ou chaque cellule électrochimique (15) comprenant :
- une membrane électrolytique (22),
- un conduit anodique (30) pour la circulation d'un flux anodique, comprenant un fluide réducteur, le long d'un premier côté de la membrane (22),
- un conduit cathodique (32) pour la circulation d'un flux cathodique, comprenant le fluide oxydant, le long d'un deuxième côté de la membrane (22), et
- des moyens (58, 59A, 59B) de circulation d'un courant électrique entre les deux côtés de la membrane (22),
**caractérisé en ce qu'**il comprend en outre :
- des moyens (49A, 50) d'alimentation de la ou chaque cellule (15) en flux anodique et cathodique, le flux anodique étant à une première pression et circulant à un premier débit dans le conduit anodique, le flux cathodique circulant à un deuxième débit dans le conduit cathodique,
- des moyens (49B, 51, 57, 59C) de commande d'au moins un paramètre commandé parmi les paramètres suivants :
∘ pression du flux anodique dans le conduit anodique de la ou chaque cellule,
∘ pression du flux cathodique dans le conduit cathodique de la ou chaque cellule,
∘ débit du flux anodique dans le conduit anodique de la ou chaque cellule,
∘ débit du flux cathodique dans le conduit cathodique de la ou chaque cellule, et
∘ intensité du courant échangé entre les deux côtés de la membrane de la ou chaque cellule,
- au moins un capteur (60, 80), pour mesurer une première concentration (C₁) en fluide réducteur dans un premier flux comprenant le flux cathodique sortant du conduit cathodique (32) de la ou d'au moins une des cellule(s) électrochimique(s) (15), et
- des moyens (61) configurés pour détecter une fuite de fluide réducteur au travers de la membrane électrolytique (22) de la ou de l'une des cellule(s) électrochimique(s) (15), en fonction de l'évolution dans le temps de la première concentration en fluide réducteur (C₁) mesurée après une variation brusque et commandée du paramètre commandé ou d'au moins un des paramètres commandés.

13. Système de pile à combustible (12) selon la revendication 12, comprenant une pluralité de cellules électrochimiques (15) regroupées au sein d'un premier empilement (14A), ledit premier empilement (14A) comprenant un premier collecteur cathodique (40), pour collecter le flux cathodique sortant du conduit cathodique de chaque cellule électrochimique (15) de l'empilement (14A), le premier flux étant un flux circulant en un premier point de mesure (44) dudit collecteur cathodique (40).

14. Système de pile à combustible (12) selon la revendication 13, comprenant une vanne multivoies (84, 92), pour mettre le capteur (60) en communication fluidique sélectivement avec le premier point de mesure (44), ou avec un deuxième point de mesure (82) du premier collecteur cathodique (40).

15. Système de pile à combustible (12) selon la revendication 13 ou 14, comprenant un deuxième empilement (14B) de cellules électrochimiques (15) avec un deuxième collecteur cathodique, et une vanne multivoies (92) pour mettre le capteur (60) en communication fluidique sélectivement avec le premier point de mesure (44), ou avec un troisième point de mesure du deuxième collecteur cathodique.

16. Système de pile à combustible (12) selon l'une quelconque des revendications 13 à 15, dans lequel les moyens de détection (61) sont adaptés pour localiser la fuite parmi les cellules (15) de l'empilement (14A) en fonction d'un retard entre un instant (t₀) de variation brusque du paramètre commandé ou d'au moins un des paramètres commandés et un instant (t₁) de variation significative de la première concentration (C₁).

17. Système de pile à combustible (12) selon l'une quelconque des revendications 12 à 16, comprenant un dispositif (54) de réinjection d'une partie du flux cathodique sortant de la ou chaque cellule électrochimique (15) en entrée du conduit cathodique (32) de la ou chaque cellule électrochimique (15).

## Patentansprüche

1. Verfahren zur Detektion einer Leckage eines Reduktionsfluids durch eine elektrolytische Membran (22) einer elektrochemischen Zelle (15), wobei die Membran (22) zwischen einem anodischen Kanal (30) zum Strömenlassen eines anodischen Flusses, welcher das Reduktionsfluid aufweist, entlang einer ersten Seite der Membran (22) und einem kathodischen Kanal (32) zum Strömenlassen eines kathodischen Flusses, welcher das Oxidationsfluid aufweist, entlang einer zweiten Seite der Membran (22) angeordnet ist, wobei die elektrochemische Zelle (15) Mittel zum Strömenlassen eines elektrischen Stroms zwischen den zwei Seiten der Membran (22) aufweist, **gekennzeichnet dadurch, dass** das Verfahren die folgenden aufeinanderfolgenden Schritte aufweist:
- Versorgen der Zelle (15) mit einem anodischen und einem kathodischen Fluss, wobei der anodische Fluss einen ersten Druck aufweist und mit einem ersten Durchsatz in dem anodischen Kanal (30) strömt, wobei der kathodische Fluss einen zweiten Druck aufweist und mit einem zweiten Durchsatz in dem kathodischen Kanal (32) strömt, und wobei ein Strom einer ersten Stärke zwischen den zwei Seiten der Membran (22) ausgetauscht wird,
- Abruptes und gesteuertes Verändern mindestens eines gesteuerten Parameters unter den folgenden Parametern:
∘ Druck des anodischen Flusses in dem anodischen Kanal,
∘ Druck des kathodischen Flusses in dem kathodischen Kanal,
∘ Durchsatz des anodischen Flusses in dem anodischen Kanal,
∘ Durchsatz des kathodischen Flusses in dem kathodischen Kanal, und
∘ Stärke des Stroms, der zwischen den zwei Seiten der Membran ausgetauscht wird,
- Messen einer ersten Konzentration (C₁) an Reduktionsfluid in einem ersten Fluss, welcher den kathodischen Fluss, der den kathodischen Kanal verlässt, aufweist, und
- Rückschließen auf das Vorliegen oder die Abwesenheit einer Leckage in Abhängigkeit von der zeitlichen Entwicklung der gemessenen, ersten Konzentration an Reduktionsfluid (C₁).

2. Verfahren zur Detektion gemäß dem Anspruch 1, wobei der erste Fluss durch den kathodischen Fluss, der den kathodischen Kanal (32) verlässt, gebildet ist.

3. Verfahren zur Detektion gemäß dem Anspruch 1, wobei die elektrochemische Zelle (15) Teil eines Stapels (14A) aus einer Mehrzahl von elektrochemischen Zellen ist, wobei der kathodische Fluss, welcher aus jeder der elektrochemischen Zellen austritt, in einem für die elektrochemischen Zellen gemeinsamen, kathodischen Sammler (40) gesammelt wird, wobei der erste Fluss ein Fluss ist, welcher an einem ersten Messpunkt (44) des kathodischen Sammlers (40) strömt.

4. Verfahren zur Detektion gemäß dem Anspruch 3, aufweisend die folgenden zusätzlichen Schritte:
- Messen einer zweiten Konzentration (C₃) an Reduktionsfluid in einem zweiten Fluss, welcher an einem zweiten Messpunkt (82) des kathodischen Sammlers (40) strömt,
- Vergleichen der ersten (C₁) und der zweiten (C₃) gemessenen Konzentration an Reduktionsfluid miteinander, und
- Lokalisieren der Leckage unter den Zellen des Stapels (14A) in Abhängigkeit von der zeitlichen Veränderung der ersten und der zweiten gemessenen Konzentration (C₁, C₃) relativ zueinander.

5. Verfahren zur Detektion gemäß dem Anspruch 4, wobei, gemäß einer Strömungsrichtung des Fluids in dem kathodischen Sammler (40), der zweite Messpunkt (82) stromaufwärts der Zelle (15), in welcher die Leckage detektiert wird, angeordnet ist.

6. Verfahren zur Detektion gemäß irgendeinem der Ansprüche 3 bis 5, wobei der Stapel (14A) der elektrochemischen Zellen Teil eines Brennstoffzelle-Systems (12) ist, welches den Stapel (14A), ein Mehrwegeventil (84, 92) und einen Wasserstoffsensor (60) aufweist, wobei das Verfahren die folgenden zusätzlichen Schritte aufweist:
- Fluidverbinden eines ersten Einlasswegs (88A, 94A) des Mehrwegeventils (84, 92), welcher mit dem ersten Messpunkt (44) fluidverbunden ist, mit einem Auslassweg (88C, 94E) des Mehrwegeventils (84, 92), welcher mit dem Wasserstoffsensor (60) verbunden ist, dann
- Messen der ersten Konzentration an Reduktionsfluid (C₁) mittels des Wasserstoffsensors (60).

7. Verfahren zur Detektion gemäß dem Anspruch 6, aufweisend die folgenden zusätzlichen Schritte:
- Fluidverbinden eines zweiten Einlasswegs (88B, 94B) des Mehrwegeventils (84, 92), welcher mit dem zweiten Messpunkt (82) fluidverbunden ist, mit dem Auslassweg (88C, 94E) des Mehrwegeventils (84, 92), dann
- Messen der zweiten Konzentration an Reduktionsfluid (C₃) mittels des Wasserstoffsensors (60).

8. Verfahren zur Detektion gemäß dem Anspruch 6 oder 7, wobei das Brennstoffzelle-System (12) einen zweiten Stapel (14B) aus elektrochemischen Zellen aufweist, wobei das Verfahren die folgenden zusätzlichen Schritte aufweist:
- Fluidverbinden eines dritten Einlasswegs (94D) des Mehrwegeventils (92), welcher mit einem kathodischen Sammler (40) des zweiten Stapels (14B) fluidverbunden ist, mit dem Auslassweg (94E) des Mehrwegeventils (92), dann
- Messen, mittels des Wasserstoffsensors (60), einer dritten Konzentration an Reduktionsfluid (C₂) in einem dritten Fluss, welcher in dem kathodischen Sammler (40) des zweiten Stapels (14B) strömt.

9. Verfahren gemäß irgendeinem der Ansprüche 3 bis 8, aufweisend einen Schritt des Lokalisierens der Leckage in Abhängigkeit von einer Verzögerung zwischen dem Zeitpunkt (t₀) der abrupten Veränderung des gesteuerten Parameters und einem Zeitpunkt (t₁) der signifikativen Veränderung der ersten Konzentration (C₁).

10. Verfahren gemäß irgendeinem der vorhergehenden Ansprüche, wobei die abrupte Veränderung des Durchsatzes des kathodischen Flusses in dem kathodischen Kanal (40) bewirkt wird mittels Wiedereinspeisens eines Teils des austretenden kathodischen Flusses in einen Eingang des kathodischen Kanals.

11. Verfahren gemäß irgendeinem der vorhergehenden Ansprüche, wobei bei dem Schritt des abrupten Veränderns mindestens zwei der gesteuerten Parameter simultan oder sequentiell variiert werden.

12. Brennstoffzelle-System (12), aufweisend mindestens eine elektrochemische Zelle (15), wobei die oder jede elektrochemische Zelle (15) aufweist:
- eine elektrolytische Membran (22),
- einen anodischen Kanal (30) zum Strömenlassen eines anodischen Flusses, welcher ein Reduktionsfluid aufweist, entlang einer ersten Seite der Membran (22),
- einen kathodischen Kanal (32) zum Strömenlassen eines kathodischen Flusses, welcher ein Oxidationsfluid aufweist, entlang einer zweiten Seite der Membran (22), und
- Mittel (58, 59A, 59B) zum Strömenlassen eines elektrischen Stroms zwischen den zwei Seiten der Membran (22), **gekennzeichnet dadurch, dass** es ferner aufweist:
- Mittel (49A, 50) zur Versorgung der oder jeder Zelle (15) mit dem anodischen und dem kathodischen Fluss, wobei der anodische Fluss einen ersten Druck aufweist und mit einem ersten Durchsatz in dem anodischen Kanal strömt, wobei der kathodische Fluss mit einem zweiten Durchsatz in dem kathodischen Kanal (32) strömt,
- Mittel (49B, 51, 57, 59C) zum Steuern mindestens eines gesteuerten Parameters unter den folgenden Parametern:
∘ Druck des anodischen Flusses in dem anodischen Kanal der oder jeder Zelle,
∘ Druck des kathodischen Flusses in dem kathodischen Kanal der oder jeder Zelle,
∘ Durchsatz des anodischen Flusses in dem anodischen Kanal der oder jeder Zelle,
∘ Durchsatz des kathodischen Flusses in dem kathodischen Kanal der oder jeder Zelle, und
∘ Stärke des Stroms, der zwischen den zwei Seiten der Membran der oder jeder Zelle ausgetauscht wird,
- mindestens einen Sensor (60, 80) zum Messen einer ersten Konzentration (C₁) an Reduktionsfluid in einem ersten Fluss, welcher den kathodischen Fluss, der den kathodischen Kanal (32) von der elektrischen Zelle (15) oder von mindestens einer der elektrischen Zellen (15) verlässt, aufweist, und
- Mittel (61), welche eingerichtet sind, um, in Abhängigkeit von der zeitlichen Entwicklung der gemessenen, ersten Konzentration an Reduktionsfluid (C₁) nach einer abrupten und gesteuerten Veränderung des gesteuerten Parameters oder mindestens eines der gesteuerten Parameter, eine Leckage des Reduktionsfluids durch die elektrolytische Membran (22) von der elektrischen Zelle (15) oder von einer der elektrischen Zellen (15) zu detektieren.

13. Brennstoffzelle-System (12) gemäß dem Anspruch 12, aufweisend eine Mehrzahl von elektrochemischen Zellen (15), welche innerhalb eines ersten Stapels (14A) zusammengefasst sind, wobei der erste Stapel (14A) einen ersten kathodischen Sammler (40) zum Sammeln des kathodischen Flusses, welcher den kathodischen Kanal jeder elektrochemischen Zelle (15) des Stapels (14A) verlässt, aufweist, wobei der erste Fluss ein Fluss ist, welcher an einem ersten Messpunkt (44) des kathodischen Sammlers (40) strömt.

14. Brennstoffzelle-System (12) gemäß dem Anspruch 13, aufweisend ein Mehrwegeventil (84, 92) zum selektiven Fluidverbinden des Sensors (60) mit dem ersten Messpunkt (44) oder mit einem zweiten Messpunkt (82) des ersten kathodischen Sammlers (40).

15. Brennstoffzelle-System (12) gemäß dem Anspruch 13 oder 14, aufweisend einen zweiten Stapel (14B) aus elektrochemischen Zellen (15) mit einem zweiten kathodischen Sammler, und ein Mehrwegeventil (94) zum selektiven Fluidverbinden des Sensors (60) mit dem ersten Messpunkt (44) oder mit einem dritten Messpunkt des zweiten kathodischen Sammlers.

16. Brennstoffzelle-System (12) gemäß irgendeinem der Ansprüche 13 bis 15, wobei die Mittel zur Detektion (61) eingerichtet sind, um die Leckage unter den Zellen (15) des Stapels (14A) zu lokalisieren in Abhängigkeit von einer Verzögerung zwischen einem Zeitpunkt (t₀) der abrupten Veränderung des gesteuerten Parameters oder mindestens eines der gesteuerten Parameter und einem Zeitpunkt (t₁) der signifikativen Veränderung der ersten Konzentration (C₁).

17. Brennstoffzelle-System (12) gemäß irgendeinem der Ansprüche 12 bis 16, aufweisend eine Vorrichtung (54) zur Wiedereinspeisung eines Teils des kathodischen Flusses, der die oder jede elektrochemische Zelle (15) verlässt, in einen Eingang des kathodischen Kanals (32) der oder jeder elektrochemischen Zelle (15).

## Claims

1. A method for detecting leakage of a reducing fluid throughout an electrolyte membrane (22) of an electrochemical cell (15), the membrane (22) being interposed between an anode channel (30) for the flow of an anode stream, comprising the reducing fluid, along a first side of the membrane (22), and a cathode channel (32) for the flow of a cathode stream, comprising the oxidizing fluid, along a second side of the membrane (22), the electrochemical cell (15) comprising means for the flow of electric current between the two sides of the membrane (22), **characterized in that** the method comprises the following successive steps:
- supplying the cell (15) with anode and cathode streams, the anode stream being at a first pressure and flowing at a first flow rate in the anode channel (30), the cathode stream being at a second pressure and flowing at a second flow rate in the cathode channel (32), and a current with a first intensity being exchanged between the two sides of the membrane (22),
- varying at least one controlled parameter abruptly and in a controlled manner, said parameter being chosen from among the following parameters:
∘ pressure of the anode stream in the anode channel,
∘ pressure of the cathode stream in the cathode channel,
∘ flow rate of the anode stream in the anode channel,
∘ flow rate of the cathode stream in the cathode channel, and
∘ intensity of the current exchanged between the two sides of the membrane,
- measuring a first concentration (C₁) of reducing fluid in a first stream comprising the cathode stream leaving the cathode channel, and
- deducing the presence or absence of a leakage based on the evolution over time of the first measured concentration (C₁) of reducing fluid.

2. The detection method according to claim 1, wherein the first stream consists in the cathode stream leaving the cathode channel (32).

3. The detection method according to claim 1, wherein the electrochemical cell (15) is part of a stack (14A) of a plurality of electrochemical cells, the cathode stream which leaves each of said electrochemical cells being collected in a cathode collector (40) shared by the electrochemical cells, the first stream being a stream flowing at a first measuring point (44) of said cathode collector (40).

4. The detection method according to claim 3, comprising the following additional steps:
- measuring a second reducing fluid concentration (C₃) in a second stream flowing at a second measuring point (82) of the cathode collector (40),
- comparing the first (C₁) and second (C₃) measured reducing fluid concentrations to one another, and
- locating the leakage among the cells of the stack (14A) depending on the variation over time of said first and second measured concentrations (C₁, C₃) relative to one another.

5. The detection method according to claim 4, wherein the second measuring point (82) is positioned upstream from the cell (15) in which the leakage is detected, relative to a fluid flow direction in the cathode collector (40).

6. The detection method according to any one of claims 3 to 5, wherein the stack (14A) of electrochemical cells is part of a fuel cell system (12) comprising the stack (14A), a multi-channel valve (84, 92) and a dihydrogen sensor (60), the method comprising the following additional steps:
- placing a first inlet channel (88A, 94A) of the multi-channel valve (84, 92), fluidly connected to the first measuring point (44), in fluid communication with an outlet channel (88C, 94E) of the multi-channel valve (84, 92), fluidly connected to the dihydrogen sensor (60), then
- measuring the first concentration of reducing fluid (C₁) using the dihydrogen sensor (60).

7. The detection method according to claim 6, comprising the following additional steps:
- placing a second inlet channel (88B, 94B) of the multi-channel valve (84, 92), fluidly connected to the second measuring point (82), in fluid communication with the outlet channel (88C, 94E) of the multi-channel valve (84, 92), then
- measuring the second concentration of reducing fluid (C₃) using the dihydrogen sensor (60).

8. The detection method according to claim 6 or 7, wherein the fuel cell system (12) comprises a second stack (14B) of electrochemical cells, the method comprising the following additional steps:
- placing a third inlet channel (94D) of the multi-channel valve (92), fluidly connected to a cathode collector (40) of the second stack (14B), in fluid communication with the outlet channel (94E) of the multi-channel valve (92), then
- measuring, using the dihydrogen sensor (60), a third reducing fluid concentration (C₂) in a third stream flowing in the cathode collector (40) of the second stack (14B).

9. The method according to any one of claims 3 to 8, comprising a step for locating the leakage based on a delay between the moment (t₀) of abrupt variation of the controlled parameter and a moment (t₁) of significant variation of the first concentration (C₁).

10. The method according to any one of the preceding claims wherein the abrupt variation of the flow rate of the cathode stream in the cathode channel (40) is obtained by reinjecting part of the exiting cathode stream at the inlet of the cathode channel.

11. The method according to any one of the preceding claims, wherein, during the abrupt variation step, at least two of the parameters vary simultaneously or sequentially.

12. A fuel cell system (12), comprising at least one electrochemical cell (15), the or each electrochemical cell (15) comprising:
- an electrolyte membrane (22),
- an anode channel (30) for the flow of an anode stream, comprising a reducing fluid, along a first side of the membrane (22),
- a cathode channel (32) for the flow of a cathode stream, comprising the oxidizing fluid, along a second side of the membrane (22), and
- means (58, 59A, 59B) for the flow of an electric current between the two sides of the membrane (22),
**characterized in that** it further comprises:
- means (49A, 50) for supplying the or each cell (15) with anode and cathode streams, the anode stream being at a first pressure and flowing at a first flow rate in the anode channel, the cathode stream flowing at a second flow rate in the cathode channel,
- means (49B, 51, 57, 59C) for controlling at least one controlled parameter from among the following parameters:
∘ pressure of the anode stream in the anode channel of the or each cell,
∘ pressure of the cathode stream in the cathode channel of the or each cell,
∘ flow rate of the anode stream in the anode channel of the or each cell,
∘ flow rate of the cathode stream in the cathode channel of the or each cell, and
∘ intensity of the current exchanged between the two sides of the membrane of the or each cell,
- at least one sensor (60, 80), to measure a first reducing fluid concentration (C₁) in a first stream comprising the cathode stream leaving from the cathode channel (32) of the or at least one of the electrochemical cell(s) (15), and
- means (61) configured for detecting a leakage of reducing fluid through the electrolyte membrane (22) of the or one of the electrochemical cell(s) (15), depending on the evolution over time of the first reducing fluid concentration (C₁) measured after an abrupt and controlled variation of the controlled parameter or of at least one of the controlled parameters.

13. The fuel cell system (12) according to claim 12, comprising a plurality of electrochemical cells (15) grouped together within a first stack (14A), said first stack (14A) comprising a first cathode collector (40), to collect the cathode stream leaving the cathode channel of each electrochemical cell (15) of the stack (14A), the first stream being a stream flowing at a first measuring point (44) of said cathode collector (40).

14. The fuel cell system (12) according to claim 13, comprising a multi-channel valve (84, 92) to place the sensor (60) in fluid communication selectively with the first measuring point (44), or with a second measuring point (82) of the first cathode collector (40).

15. The fuel cell system (12) according to claim 13 or 14, comprising a second stack (14B) of electrochemical cells (15) with a second cathode collector, and a multi-channel valve (92) to place the sensor (60) in fluid communication selectively with the first measuring point (44) or with a third measuring point of the second cathode collector.

16. The fuel cell system (12) according to any one of claims 13 to 15, wherein the detection means (61) are suitable for locating a leakage among the cells (15) of the stack (14A) based on a delay between the moment (t₀) of abrupt variation of the controlled parameter or at least one of the controlled parameters and a moment (t₁) of significant variation of the first concentration (C₁).

17. The fuel cell system (12) according to any one of claims 12 to 16, comprising a device (54) for reinjecting part of the cathode stream leaving the or each electrochemical cell (15) at the inlet of the cathode channel (32) of the or each electrochemical cell (15).
